# EUROPÄISCHE PATENTANMELDUNG

(11) **EP 4 564 849 A1**
(43) Veröffentlichungstag der Anmeldung: **04.06.2025**
(21) Anmeldenummer: 24214320.4
(22) Anmeldetag: 20.11.2024
(51) Int. Cl.: H04R 17/00, B81B 3/00, H04R 31/00, H04R 7/04, H04R 7/20

(54) **MEMS-WANDLER MIT ZUMINDEST EINER METALL- UND EINER OXIDSCHICHT**

(30) Priorität: 29.11.2023 DE 102023133448
(71) Anmelder: USound GmbH, 8020 Graz (AT)
(72) Erfinder: RUSCONI CLERICI BELTRAMI, Andrea, 1130 Wien (AT); BOTTONI, Ferruccio, 8020 Graz (AT); NOVOTNY, Christian, 1120 Wien (AT); HORVÁTH, Samu Bence, 1020 Wien (AT)
(74) Vertreter: Canzler & Bergmeier Patentanwälte Partnerschaft mbB

(57) **Zusammenfassung**

Die Erfindung betrifft einen MEMS-Wandler (1), insbesondere MEMS-Schallwandlereinheit, vorzugsweise zum Erzeugen und/oder Erfassen von Schallwellen im hörbaren Wellenlängenspektrum und/oder im Ultraschallbereich, mit einem Träger (2) und mit zumindest einem am Träger (2) angeordneten und in Richtung einer Hubachse (3) auslenkbaren Piezoelement (4), das zumindest eine Piezoschicht (5, 25, 35, 36) und zumindest eine Trägerschicht (6) aufweist, wobei mittels der zumindest einen Piezoschicht (5, 25, 35, 36) elektrische Signale und Auslenkungen des Piezoelements (4) ineinander umwandelbar sind. Erfindungsgemäß umfasst die Trägerschicht (6) zumindest eine Metallschicht (41 - 43) und zumindest eine Oxidschicht (37 - 40). Außerdem betrifft die Erfindung eine Verwendung der Strukturschicht (6) für MEMS-Wandler (1) und ein Herstellungsverfahren des MEMS-Wandlers (1).

## Beschreibung

Die vorliegende Erfindung betrifft einen MEMS-Wandler, insbesondere eine MEMS-Schallwandlereinheit, vorzugsweise zum Erzeugen und/oder Erfassen von Schallwellen im hörbaren Wellenlängenspektrum und/oder im Ultraschallbereich, mit einem Träger und mit zumindest einem am Träger angeordneten und in Richtung einer Hubachse auslenkbaren Piezoelement, das zumindest eine Piezoschicht und zumindest eine Trägerschicht aufweist, wobei mittels der zumindest einen Piezoschicht elektrische Signale und Auslenkungen des Piezoelements ineinander umwandelbar sind.

Aufgabe der vorliegenden Erfindung ist es, einen leistungsstarken MEMS-Wandler zu schaffen.

Die Aufgabe wird gelöst durch einen MEMS-Wandler, eine Verwendung einer Trägerschicht für einen MEMS-Wandler und ein Herstellungsverfahren des MEMS-Wandlers mit den Merkmalen der unabhängigen Patentansprüche. Vorteilhafte oder bevorzugte Ausführungen sind jeweils Gegenstand eines korrespondierenden abhängigen Anspruchs.

Vorgeschlagen wird ein MEMS-Wandler, vorzugsweise ein MEMS-Schallwandler, insbesondere zum Erzeugen und/oder Erfassen von Schallwellen im hörbaren Wellenlängenspektrum und/oder im Ultraschallbereich. Der MEMS-Wandler kann als Lautsprecher und/oder als Mikrofon und somit als MEMS-Schallwandler betrieben werden.

Der MEMS-Schallwandler umfasst einen Träger.

Des Weiteren umfasst der MEMS-Wandler zumindest ein am Träger angeordnetes und in Richtung einer Hubachse auslenkbares Piezoelement.

Außerdem weist das zumindest eine Piezoelement zumindest eine Piezoschicht und zumindest eine Trägerschicht auf, wobei mittels der Piezoschichten elektrische Signale und Auslenkungen des Piezoelements ineinander umwandelbar sind.

Des Weiteren umfasst die Trägerschicht zumindest eine Metallschicht und zumindest eine Oxidschicht.

Vorteilhaft ist es, wenn die Piezoschichten aus Scandium-Aluminium-Nitrit ausgebildet sind. Derartige Piezoschichten sind sehr robust, was insbesondere an dem Scandiumanteil liegt, der vorzugsweise zwischen 30% und 70% betragen kann. Besonders vorteilhaft kann es sein, wenn der Scandiumanteil 30%, 40 oder 50% beträgt.

Von Vorteil ist es, wenn in Richtung der Hubachse unterhalb oder oberhalb der Trägerschicht die zumindest eine Piezoschicht angeordnet ist.

Ebenso ist es von Vorteil, wenn in Richtung der Hubachse unterhalb oder oberhalb der Trägerschicht zwei Piezoschichten angeordnet sind.

Vorteilhaft ist es ferner, wenn die Metallschicht eine Aluminiumschicht ist. Zusätzlich oder alternativ ist es von Vorteil, wenn die Oxidschicht eine Siliziumoxidschicht ist. Mittels dieser Materialien kann die Trägerschicht mit bekannten Herstellungsverfahren, beispielsweise mittels Verfahren, die in der Halbleitertechnologie eingesetzt werden, ausgebildet werden. Die Trägerschicht kann infolgedessen in großen Mengen und/oder sehr kostengünstig hergestellt werden. Des Weiteren weise die Aluminium- und die Siliziumoxidschicht ein vergleichbares E-Modul von im Bereich von 70GPa auf. Dadurch weisen beide Schichten ähnlich bzw. fast gleiche Auslenkeigenschaften auf.

Die zumindest eine Oxidschicht und/oder zumindest eine Metallschicht weisen ferner den Vorteil auf, dass diese thermisch bis hohe Temperaturen, beispielsweise bis 1200°C - 1400°C, beständig sind. Infolgedessen können die Piezoschichten und/oder Elektrodenschichten mittels Verfahren der Halbleitertechnologie, beispielsweise eine CMOS-kompatiblen Verfahren, aufgebracht werden. Beispielsweise können die Piezoschichten und/oder die Elektrodenschichten mittels eines CVD-Verfahrens (chemische Gasphasenabscheidung) aufgebracht werden.

Ferner ist es von Vorteil, wenn die Trägerschicht mehrere Metallschichten und mehrere Oxidschichten umfasst. Die Metall- und die Oxidschichten können außerdem abwechselnd übereinander angeordnet und/oder gestapelt sein. Hierdurch wird ein sandwichartiger Aufbau der Trägerschicht ausgebildet. Eine derartige Trägerschicht ist somit ein Stapel aus mehreren Schichten, vorzugsweise aus zumindest einer Metallschicht und zumindest einer, insbesondere zumindest zwei, Oxidschichten. Die Trägerschicht kann hierbei auch eine Strukturschicht sein.

Von Vorteil ist es, wenn in Richtung der Hubachse die oberste oder die unterste Schicht eine Oxidschicht ist. Beim schichtweisen Aufbau der Trägerschicht mittels der zumindest einen Metallschicht und zumindest zwei Oxidschichten ist in Richtung der Hubachse die oberste und/oder die unterste Schicht eine Oxidschicht. Dies hat den Vorteil, dass die Oxidschicht, insbesondere die Siliziumoxidschicht, die höchste Temperaturbeständigkeit aufweist. Auf diese Oxidschichten, die sowohl die oberste als auch die unterste Schicht bilden, wird die Piezoschicht und/oder die Elektrodenschicht, insbesondere bei höheren Temperaturen, aufgetragen. Die Oxidschicht verändert sich bei den höheren Temperaturen nicht.

Die Oxidschicht, insbesondere die Siliziumoxidschicht, kann außerdem auf einfache Weise bearbeitet werden. Beispielsweise kann diese Schicht chemisch-mechanisch poliert werden. Ein derartiges Verfahren ist unter Chemisch-mechanisches Polieren, auch chemisch-mechanisches Planarisieren (CMP, engl: "chemical mechanical polishing", auch "chemical mechanical planarization") bekannt. Die Oxidschicht, insbesondere die Siliziumoxidschicht, kann dadurch sehr flach und/oder eben ausgebildet werden.

Es bringt Vorteile, wenn das Piezoelement in seiner Längsrichtung eine Länge, insbesondere vom Träger bis zu einem freien Ende des Piezoelements, zwischen 0,5mm und 2mm aufweist.

Vorteilhaft ist es, wenn in Richtung der Hubachse lediglich auf einer Seite der Trägerschicht die zumindest eine Piezoschicht angeordnet ist.

Zusätzlich oder alternativ ist es von Vorteil, wenn in Richtung der Hubachse auf einer Seite der Trägerschicht die zumindest eine Piezoschicht ist und die dazu gegenüberliegende Seite frei von der zumindest einen Piezoschicht ist.

Von Vorteil ist es, wenn in Richtung der Hubachse die zumindest eine Piezoschicht, lediglich und/oder ausschließlich, zwischen Träger und Trägerschicht angeordnet ist. Durch die beschriebene Anordnung der zumindest einen Piezoschicht lediglich auf einer Seite der Trägerschicht kann das Piezoelement auf einfache Weise und unkompliziert hergestellt werden.

Vorteilhaft ist es, wenn das zumindest eine Piezoelement mehrere, insbesondere zwischen zwei und sechs, vorzugsweise vier, Piezoschichten umfasst.

Ein Vorteil resultiert, wenn das zumindest eine Piezoelement zumindest eine Elektrodenschicht umfasst. Mit Hilfe der zumindest einen Elektrodenschicht können die elektrischen Signale ausgetauscht werden, die zur Auslenkung des Piezoelements führen und/oder die ausgebildet werden, wenn das Piezoelement ausgelenkt wird.

Von Vorteil ist es, wenn das zumindest eine Piezoelement zumindest eine Isolationsschicht umfasst.

Vorteilhaft ist es, wenn das zumindest eine Piezoelement sandwichartig aus den mehreren Piezoschichten und den Elektrodenschichten ausgebildet ist.

Ein Vorteil resultiert, wenn der MEMS-Schallwandler ein Koppelelement umfasst, mit dem das zumindest eine Piezoelement mit einer Membran koppelbar ist.

Eine Verbesserung resultiert, wenn das Piezoelement und das Koppelelement mittels zumindest eines Federelements miteinander gekoppelt sind, wobei das zumindest eine Federelement in Längsrichtung des Piezoelements vorzugsweise zwischen der Trägerschicht und dem Koppelelement angeordnet ist.

Vorteile bringt es mit sich, wenn das Federelement, vorzugsweise ausschließlich, durch die Trägerschicht ausgebildet ist. Hierdurch kann das Federelement auf einfache Weise ausgebildet werden.

Von Vorteil ist es, wenn das Federelement aus dem oder einem Polymer, insbesondere aus Polyamid, ausgebildet ist. Zusätzlich oder alternativ weist das Federelement die mechanischen Eigenschaften des Polymers auf.

Es ist förderlich, wenn das Piezoelement und das Koppelelement zueinander denselben schichtweisen Aufbau aufweisen.

Eine Verbesserung resultiert, wenn die Trägerschicht zwischen 5µm und 100µm dick ist. Vorzugsweise weist die Trägerschicht eine Dicke geringer als 100µm auf.

Des Weiteren ist es vorteilhaft, wenn die Trägerschicht ein E-Modul zwischen 40 und 300GPa aufweist.

Durch die oben genannten mechanischen Eigenschaften der zumindest einen Trägerschicht können die Auslenkungen vergrößert und/oder das Piezoelement bei zumindest gleichbleibender Größe der Auslenkung oder bei Vergrößerung der Auslenkung verkürzt werden.

Des Weiteren ist es von Vorteil, wenn das Piezoelement zumindest eine Kompensationsschicht umfasst. Diese Kompensationsschicht kann auf der Trägerschicht und/oder auf der zumindest einen Piezoschicht angeordnet sein. Die Trägerschicht kann zwischen Kompensationsschicht und der zumindest einen Piezoschicht angeordnet sein. Mit Hilfe der Kompensationsschicht kann die neutrale Ebene entlang der Hubachse verschoben werden.

Außerdem ist es vorteilhaft, wenn die zumindest eine Piezoschicht in Richtung der Hubachse zwischen Träger und Trägerschicht angeordnet ist.

Des Weiteren wird eine Verwendung der Trägerschicht für den MEMS-Wandler vorgeschlagen. Der MEMS-Wandler weist dabei zumindest ein Merkmal der vorangegangenen und/oder nachfolgenden Beschreibung auf. Zusätzlich oder alternativ weist die Trägerschicht zumindest ein Merkmal der vorangegangenen und/oder nachfolgenden Beschreibung auf. Insbesondere kann die Trägerschicht zumindest eine Metallschicht, insbesondere eine Aluminiumschicht, und/oder zumindest eine Oxidschicht, insbesondere eine Siliziumoxidschicht, und gegebenenfalls zumindest ein weiteres damit verbundenes Merkmal umfassen.

Vorgeschlagen wird außerdem ein Verfahren zur Herstellung eines MEMS-Wandlers, vorzugsweise eines MEMS-Schallwandlers, insbesondere zum Erzeugen und/oder Erfassen von Schallwellen im hörbaren Wellenlängenspektrum und/oder im Ultraschallbereich. Das Verfahren zur Herstellung des MEMS-Wandlers kann dabei derart durchgeführt werden, dass der MEMS-Wandler mit zumindest einem Merkmal der vorangegangenen und/oder nachfolgenden Beschreibung ausgebildet wird.

Beim Verfahren wird auf einem Träger zumindest ein Piezoelement ausgebildet, das zumindest zwei Piezoschichten und zumindest eine damit gekoppelte Trägerschicht umfasst.

Des Weiteren wird beim Verfahren wird die Trägerschicht zwischen zumindest zwei Piezoschichten angeordnet. Hierdurch kann ein symmetrischer Aufbau des Piezoelements, insbesondere in Richtung der Hubachse, ausgebildet werden. Infolgedessen können vorteilhafte Auslenkungseigenschaften erreicht werden.

Ebenso ist es förderlich, wenn eine Oxidschicht, insbesondere eine Siliziumoxidschicht, mittels chemisch-mechanischem Polierens bearbeitet wird. Hierdurch wird die Oxidschicht flach und/oder eben ausgebildet. Auf diese flache und/oder ebene Oxidschicht wird dann die zumindest eine Piezoschicht und/oder eine Elektrodenschicht aufgebracht.

Von Vorteil ist es, wenn die Piezoschichten mittels Halbleiterherstellungsverfahren auf der Trägerschicht ausgebildet werden.

Vorteilhaft ist es außerdem, wenn die Piezoschichten auf der Trägerschicht abgeschieden werden. Die Piezoschicht, zumindest die erste Piezoschicht, kann hierbei auch auf der Oxidschicht abgeschieden werden. Alle weiteren folgenden Piezoschichten werden dann aufeinander abgeschieden.

Ebenso ist es von Vorteil, wenn die Piezoschichten auf der Trägerschicht und/oder die Trägerschicht mittels chemischer Gasphasenabscheidung ausgebildet werden. Hierdurch werden gut verstandene Verfahren zur Ausbildung der Piezoschichten und/oder der Elektrodenschichten angewandt. Außerdem können derartige Verfahren besonders einfach durchgeführt werden.

Die Metallschicht, die Oxidschicht, die Elektrodenschicht und/oder die Piezoschicht können hierbei mit CMOS-kompatiblen Verfahren ausgebildet und/oder, insbesondere auf bereits bestehende Schichten, angeordnet werden.

Weiterhin ist es förderlich, wenn nach dem Ausbilden der Piezoschichten und/oder der Trägerschicht zumindest ein Bereich, insbesondere mittels Ätzens, entfernt wird. Mit Hilfe der hier beschriebenen Verfahrensschritte können die Piezoschichten und/oder die Trägerschicht aufeinander aufgebaut werden.

Nützlich ist es, wenn die Piezoschichten aus Scandium-Aluminium-Nitrit ausgebildet werden.

Ferner ist es vorteilhaft, wenn das zumindest eine Piezoelement mit mehreren, insbesondere zwischen zwei und sechs, insbesondere vier, Piezoschichten ausgebildet wird. Mittels mehrerer Piezoschichten kann die Leistung des Piezoelements erhöht werden.

Des Weiteren ist es von Vorteil, wenn in Richtung der Hubachse oberhalb und unterhalb der Trägerschicht die gleiche Anzahl an Piezoschichten angeordnet wird.

Beispielsweise ist es von Vorteil, wenn in Richtung der Hubachse oberhalb und unterhalb der Trägerschicht jeweils zwei Piezoschichten angeordnet sind, sodass das Piezoelement insgesamt vier Piezoschichten umfasst.

Förderlich ist es, wenn das zumindest eine Piezoelement sandwichartig aus den mehreren Piezoschichten und zumindest einer Elektrodenschicht ausgebildet wird.

Die mehreren Piezoschichten und mehreren Elektrodenschichten können abwechselnd übereinander angeordnet sein.

Des Weiteren ist es vorteilhaft, wenn beim Ausbilden des zumindest einen Piezoelements zumindest eine Isolationsschicht angeordnet wird.

Nützlich ist es, wenn die Trägerschicht aus dem Polymer auf einer dem Träger abgewandten Seite der Piezoschicht angeordnet wird.

Eine Verbesserung resultiert, wenn die Trägerschicht aus dem Polymer auf der zumindest einen Piezoschicht angeordnet wird, nachdem die Piezoschicht und/oder ein Koppelelement ausgebildet sind und/oder nachdem der Träger, die Piezoschicht und/oder das Koppelelement, insbesondere mittels Ätzens, nachbearbeitet, insbesondere voneinander getrennt, sind.

Es ist förderlich, wenn das Piezoelement und das Koppelelement zusammen schichtweise ausgebildet werden, wobei dies vorzugsweise auf dem Träger erfolgt.

Es bringt Vorteile, wenn nach dem schichtweisen Aufbauen des Piezoelements und des Koppelelements diese, insbesondere mittels Ätzens, zumindest abschnittweise voneinander getrennt werden.

Des Weiteren kann ein Verfahren durchgeführt werden, um den MEMS-Wandler gemäß einem oder mehreren der vorangegangenen und/oder nachfolgenden Beschreibung zu schaffen.

Weitere Vorteile der Erfindung sind in den nachfolgenden Ausführungsbeispielen beschrieben. Es zeigen:
- **Figur 1**: eine schematische Schnittansicht eines MEMS-Wandlers mit einem Piezoelement aus zwei Piezoschichten und zumindest einer Trägerschicht,
- **Figur 2**: eine schematische Schnittansicht des Piezoelements mit zwei Piezoschichten und zumindest einer Trägerschicht,
- **Figur 3**: eine schematische Schnittansicht des Piezoelements mit jeweils zwei Piezoschichten in Richtung der Hubachse oberhalb und unterhalb der Trägerschicht und
- **Figur 4**: eine schematische Schnittansicht der Trägerschicht aus Metallschichten und Oxidschichten.

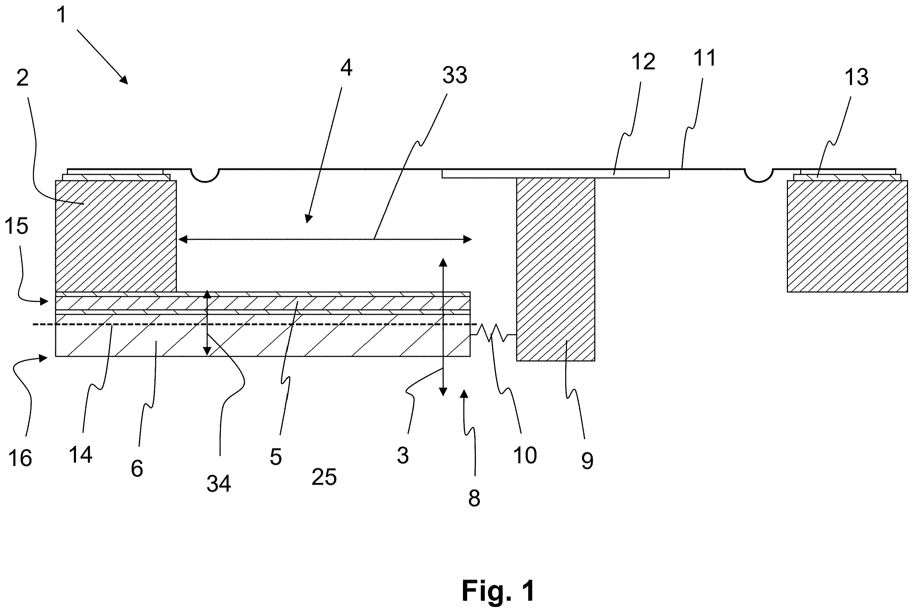

Figur 1 zeigt eine schematische Schnittansicht eines MEMS-Wandlers 1. Der MEMS-Wandler 1 kann auch ein MEMS-Schallwandler sein. Mittels des MEMS-Schallwandlers können beispielsweise Schallwellen im hörbaren Wellenlängenspektrum erzeugt werden, sodass dieser als MEMS-Lautsprecher betrieben werden kann. Mit Hilfe des MEMS-Schallwandlers können zusätzlich oder alternativ Schallwellen im hörbaren Wellenlängenspektrum erfasst werden, sodass dieser als MEMS-Mikrofon betrieben werden kann. Der MEMS-Schallwandler kann ferner beispielsweise in einem Smartphone angeordnet sein, um beispielsweise das Telefonieren oder das Hören von Musik zu ermöglichen. Der MEMS-Schallwandler kann beispielsweise auch in einem Kopfhörer angeordnet sein. Mittels des MEMS-Wandlers 1 können aber auch Drücke erzeugt und/oder Drücke erfasst werden.

Ein weiteres Anwendungsgebiet des MEMS-Schallwandlers kann aber auch die Erzeugung und/oder Erfassung von Schallwellen im Ultraschallbereich sein. Der MEMS-Schallwandler kann beispielsweise in einem Ultraschallsensor, beispielsweise einem Abstandssensor, angeordnet sein.

Der MEMS-Wandler 1 umfasst ferner einen Träger 2, der ein Grundgerüst des MEMS-Wandlers 1 bilden kann. Der Träger 2 kann beispielsweise ein Halbleitersubstrat umfassen, das in einem Ätzverfahren hergestellt sein kann. Der Träger 2 kann beispielsweise aus Silizium ausgebildet sein und/oder die Form eines Wafers aufweisen. In der vorliegenden Ansicht sind zwei Träger 2 gezeigt. Der Träger 2 kann jedoch als Rahmen ausgebildet sein, sodass in dieser hier gezeigten Schnittansicht die beiden hier gezeigten Elemente des Trägers 2 zusammenhängend sind. Beispielsweise kann der Träger 2 in einer Draufsicht rechteckig ausgebildet sein. Die Draufsicht kann beispielsweise in Richtung einer im Folgenden erläuterten Hubachse 3 orientiert sein. Die Draufsicht kann beispielsweise parallel zur Hubachse 3 sein. Beispielsweise kann das zumindest eine Piezoelement 4 zumindest teilweise einem Inneren des Trägers 2 zugewandt sein, wenn der Träger 2 beispielsweise als Rahmen ausgebildet ist.

Am Träger 2 ist des Weiteren zumindest ein Piezoelement 4 angeordnet. Das zumindest eine Piezoelement 4 kann ferner mit dem Träger 2 gekoppelt sein. Das zumindest eine Piezoelement 4 kann entlang der gezeigten Hubachse 3 ausgelenkt werden. Das zumindest eine Piezoelement 4 kann dabei elektrische Signale in Auslenkungen umwandeln, sodass der MEMS-Wandler 1 als Lautsprecher betrieben wird bzw. die Schallwellen erzeugt werden können. Zusätzlich oder alternativ können mit Hilfe des zumindest einen Piezoelements 4 auch Auslenkungen in elektrische Signale umgewandelt werden, sodass der MEMS-Wandler 1 als Mikrofon betrieben wird bzw. die Schallwellen erfasst werden können. Mittels der Auslenkungen können aber auch Drücke erzeugt werden. Zusätzlich oder alternativ können auch Drücke erfasst werden, da diese eine Auslenkung des zumindest einen Piezoelements 4 hervorrufen.

Das zumindest eine Piezoelement 4 umfasst ein freies Ende 8, das sich entlang der Hubachse 3 auslenken kann.

Das Piezoelement 4 umfasst des Weiteren zumindest eine Piezoschicht 5, 25, 35, 36. Die zumindest zwei Piezoschichten 5, 25, 35, 36 sind aus einem piezoelektrischen Material ausgebildet. Die zumindest eine Piezoschicht 5, 25, 35, 36 kann elektrische Signale in Auslenkungen und/oder Auslenkungen in elektrische Signale wandeln. Die zumindest eine Piezoschicht 5, 25, 35, 36 kann aus Scandium-Aluminium-Nitrit (ScAIN) ausgebildet sein.

Außerdem umfasst das Piezoelement 4 zumindest eine Trägerschicht 6. Diese ist mit der zumindest einen Piezoschicht 5, 25, 35, 36 gekoppelt. Zumindest eine Piezoschicht 5, 25, 35, 36 ist hier zwischen dem Träger 2 und der zumindest einen Trägerschicht 6 angeordnet. Mit Hilfe der zumindest einen Trägerschicht 6, kann die zumindest eine Piezoschicht 5, 25, 35, 36 stabilisiert werden. Ferner kann mittels der zumindest einen Trägerschicht 6 verhindert werden, dass die zumindest eine Piezoschicht 5, 25, 35, 36 beim Auslenken bricht. Die zumindest eine Trägerschicht 6 kann auch als Trägerschicht für die zumindest eine Piezoschicht 5, 25, 35, 36 dienen. In diesem Ausführungsbeispiel der Figur 1 ist eine erste Piezoschicht 5 gezeigt.

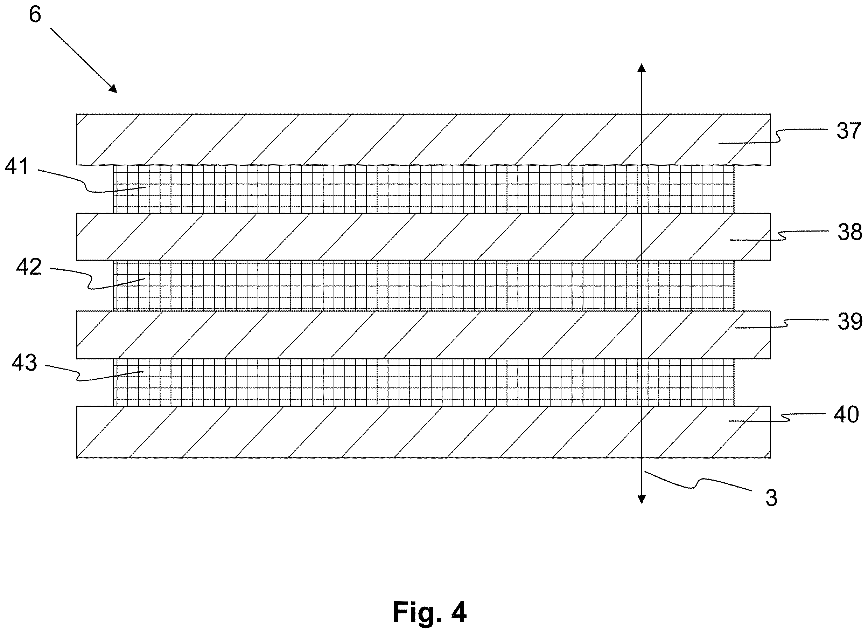

Die Trägerschicht 6 umfasst außerdem zumindest eine Metallschicht 41 - 43 und zumindest eine Oxidschicht 37 - 40, wie es detaillierter in Figur 4 gezeigt ist.

Die zumindest eine Piezoschicht 5, 25, 35, 36 ist des Weiteren lediglich auf einer Seite der Trägerschicht 6 angeordnet. Gemäß dem vorliegenden Ausführungsbeispiel ist die zumindest eine Piezoschicht 5, 25, 35, 36 in Richtung der Hubachse 3 zwischen Träger 2 und der Trägerschicht 6 angeordnet. Alternativ kann die zumindest eine Piezoschicht 5, 25, 35, 36 aber auch auf der vom Träger 2 abgewandten Seite auf der Trägerschicht 6 angeordnet sein. Infolgedessen ist in diesem alternativen Ausführungsbeispiel die Trägerschicht 6 in Richtung der Hubachse 3 zwischen Träger 2 und der zumindest einen Piezoschicht 5, 25, 35, 36 angeordnet.

Gemäß dem vorliegenden Ausführungsbeispiel umfasst der MEMS-Wandler 1 ein Koppelelement 9, mit dem das zumindest eine Piezoelement 4 mit einer hier gezeigten Membran 11 des MEMS-Wandlers 1 gekoppelt werden kann. Mithilfe des Koppelelements 9 können die Auslenkungen des Piezoelements 4 auf die Membran 11 übertragen werden, wenn mittels der Membran 11 die Schallwellen erzeugt werden, wenn der MEMS-Wandler 1 ein MEMS-Schallwandler ist. Zusätzlich oder alternativ können auch die Auslenkungen der Membranen 11, wenn mithilfe der Membran 11 die Schallwellen erfasst werden, auf das Piezoelement 4 übertragen werden, wenn der MEMS-Wandler 1 ein MEMS-Schallwandler ist.

Gemäß dem vorliegenden Ausführungsbeispiel ist das Piezoelement 4 mittels einem Federelement 10 mit dem Koppelelement 9 gekoppelt. Das Federelement 10 kann beispielsweise aus einem Polymer ausgebildet sein. Das Federelement 10 weist hierdurch eine Flexibilität auf.

Von Vorteil ist es, wenn, wie hier gezeigt ist, zwischen dem Koppelelement 9 und der Membran 11 eine Koppelplatte 12 angeordnet ist. Mittels der Koppelplatte 12 kann eine flächige Übertragung der Auslenkungen zwischen dem Koppelelement 9 und der Membran 11 erreicht werden. Gemäß dem vorliegenden Ausführungsbeispiel ist außerdem ein Membranrahmen 13 gezeigt, mit dem die Membran 11 auf dem Träger 2 angeordnet sein kann.

Des Weiteren weist das zumindest eine Piezoelement 4 eine Länge 33 auf. Die Länge 33 ist hier vom Träger 2 bis zu dem freien Ende 8 des zumindest einen Piezoelements 4 definiert. Die Länge 33 kann zwischen 0,5mm und 2mm betragen. Durch die Trägerschicht 6 kann das Piezoelement 4 diese Länge 33 aufweisen, wobei große Auslenkungen entlang der Hubachse 3 möglich sind. Die Auslenkung des zumindest einen Piezoelements 4, insbesondere an dem freien Ende 8, kann mindestens 3%, vorzugsweise mindestens 10%, betragen.

Eine Dicke 34 des zumindest einen Piezoelements 4 kann zwischen 2 µm und 50 µm betragen. Die Dicke 34 ist parallel zur Hubachse 3 und/oder senkrecht zu den Schichten des zumindest einen Piezoelements 4 orientiert (vgl. Figur 4).

Des Weiteren kann das zumindest eine Piezoelement 4 zumindest eine in dieser Figur nicht gezeigte Aussparung aufweisen. Die zumindest eine Aussparung kann sich zumindest teilweise zwischen der Oberseite 15 und der Unterseite 16 erstrecken. Die zumindest eine Aussparung kann sich von der Oberseite 15 und/oder von der Unterseite 16 in Richtung der entsprechend gegenüberliegenden Ober- bzw. Unterseite 15, 16 erstrecken. Mit Hilfe dieser Aussparungen können Spannungen im Piezoelement 4 bzw. in der zumindest einen Piezoschicht 5, 25, 35, 36 und/oder in der zumindest einen Trägerschicht 6 vermindert werden.

Die Oberseite 15 ist hier der Membran 11 zugewandt. Die Unterseite 16 ist der Membran 11 abgewandt. Durch die Begriffe Oberseite 15 und Unterseite 16 sind auch die Begriffe oberhalb und unterhalb definiert. Die Begriffe Oberseite 15 und Unterseite 16 sowie oberhalb und unterhalb beziehen sich auf die Richtung der Hubachse 3.

Des Weiteren ist hier eine neutrale Ebene 14 gezeigt. Die neutrale Ebene 14 ist ein Begriff aus der Festigkeitslehre und wird auch als neutrale Faser bzw. Nulllinie bezeichnet. Die neutrale Faser bzw. neutrale Ebene 14 bzw. die Nulllinie ist dabei die Ebene bzw. Linie im Piezoelement 4, wo sich die Zug- und Druckspannung aufheben, sodass dort keine Spannung auftritt. Darüber und darunter wirken dagegen entweder Zug- oder Druckspannungen. Die Zug- oder Druckspannung tritt hierbei natürlich nur auf, wenn sich das Piezoelement 4 auslenkt. Wird das Piezoelement 4 beispielsweise nach oben, d. h. in Richtung vom Träger 2 weg, ausgelenkt, so wirkt in einem oberen Bereich des Piezoelements 4 Druckspannung und in einem unteren Bereich des Piezoelements 4 Zugspannung. Wenn sich dagegen das Piezoelement 4 nach unten, d. h. zum Träger 2 hin, ausgelenkt, so vertauschen sich die Druckspannung und die Zugspannung. In der neutralen Ebene 14 bzw. in der neutralen Schicht wirkt weder Zugspannung noch Druckspannung, wobei diese Ebene 14 bzw. diese Schicht zwischen einer Oberseite 15 und einer Unterseite 16 des Piezoelements 4 angeordnet ist. Mit Hilfe der ersten Piezoschicht 5 und der zweiten Piezoschicht 25 in Richtung der Hubachse 3 oberhalb und unterhalb der Trägerschicht 6 ist die Position der neutralen Faser bzw. neutralen Ebene 14 (oder Schicht) bzw. der Nulllinie in der Höhe bzw. in Richtung der Hubachse 3 angepasst. Da auch die beiden Piezoschichten 5, 25, 35, 36 zueinander gleich ausgebildet sind, d. h. aus demselben Material, beispielsweise AlScN, ausgebildet sind und/oder eine gleiche Dicke 34 aufweisen, ist die neutrale Ebene 14 mittig im Piezoelement 4 und/oder in der Trägerschicht 6 angeordnet.

Der hier gezeigte MEMS-Wandler 1 weist nur ein Piezoelement 4 auf. Alternativ kann der MEMS-Wandler 1 auch mehrere Piezoelemente 4 aufweisen, die mit einer oder mit mehreren Membranen 11 gekoppelt sind.

Merkmale, welche bereits in der zumindest einen vorgegangenen Figur beschrieben sind, können der Einfachheit halber nicht nochmals erklärt werden. Ferner können Merkmale auch erst in dieser oder in zumindest einer der nachfolgenden Figuren beschrieben werden. Des Weiteren werden der Einfachheit halber für gleiche Merkmale gleiche Bezugszeichen verwendet. Außerdem können der Übersichtlichkeit halber nicht mehr alle Merkmale in den folgenden Figuren gezeigt und/oder mit einem Bezugszeichen versehen sein. Es können jedoch in einer oder mehreren der vorangegangenen Figuren gezeigte Merkmale auch in dieser oder in einer oder mehreren der nachfolgenden Figuren vorhanden sein. Ferner können der Übersichtlichkeit halber Merkmale auch erst in dieser oder in einer oder mehreren der nachfolgenden Figuren gezeigt und/oder mit einem Bezugszeichen versehen sein. Nichtsdestotrotz können Merkmale, welche erst in einer oder mehreren der nachfolgenden Figuren gezeigt sind, auch bereits in dieser oder einer vorangegangenen Figur vorhanden sein.

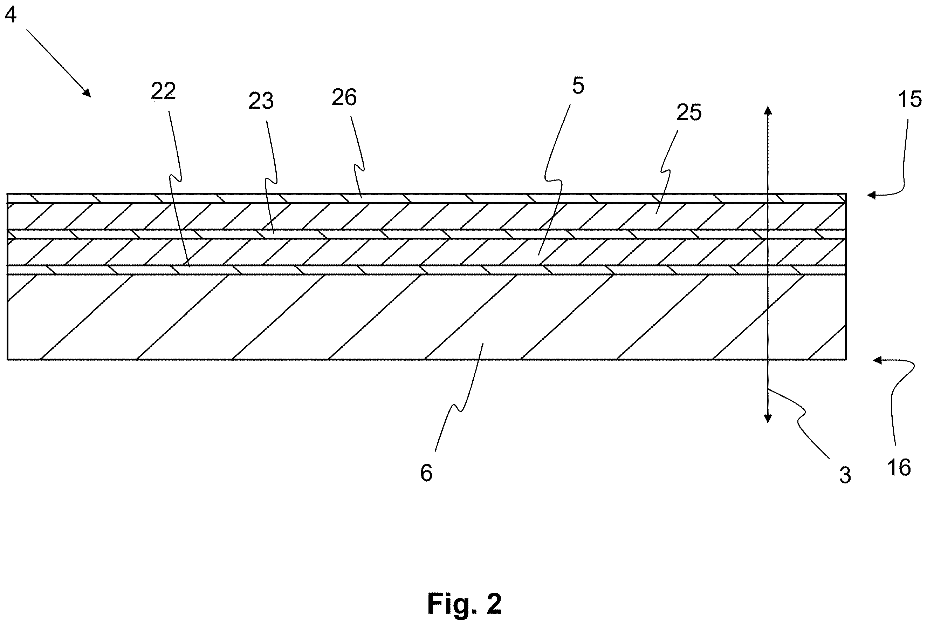

Figur 2 zeigt eine detailliertere schematische Schnittansicht des Piezoelements 4. Der Übersichtlichkeit halber wird der genauere Aufbau des Piezoelements 4 in dieser Figur 2 erläutert.

Hier sind zumindest zwei Piezoschichten 5, 25 gezeigt, wobei beide Piezoschichten 5, 25 auf einer Seite der Trägerschicht 6 angeordnet sind.

Ferner sind hier mehrere Elektrodenschichten 22, 23, 26 gezeigt. In diesem Ausführungsbeispiel sind drei Elektrodenschichten 22, 23, 26 gezeigt. Mit Hilfe der Elektrodenschichten 22, 23, 26 können die beiden Piezoschichten 5, 25 mit einem elektrischen Signal versorgt werden, sodass sie sich auslenken, oder es kann das elektrische Signal abgeführt werden, wenn sie selbst ausgelenkt werden.

Wie hier zu sehen ist, sind die Piezoschichten 5, 25 und die Elektrodenschichten 22, 23, 26 abwechselnd übereinander angeordnet. Zwischen jeweils zwei Elektrodenschichten 22, 23, 26 ist eine Piezoschicht 5, 25 angeordnet.

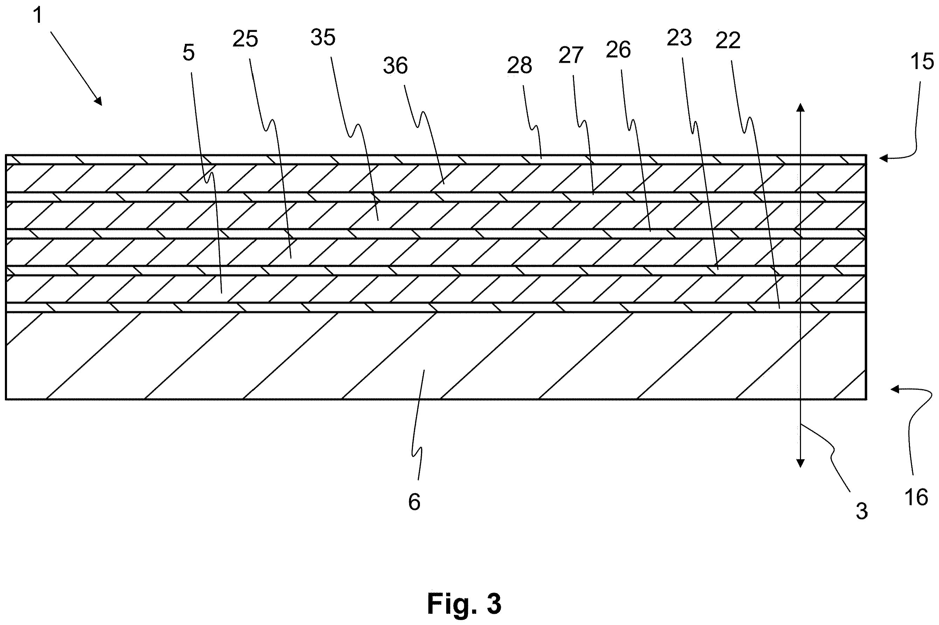

Figur 3 zeigt ein Ausführungsbeispiel des Piezoelements 4, das eine Trägerschicht 6 und vier Piezoschichten 5, 25, 35, 36, umfasst. Des Weiteren sind fünf Elektrodenschichten 22, 23, 26, 27, 28 gezeigt. Die Piezoschichten 5, 25, 35, 36, und die Elektrodenschichten 22, 23, 26, 27, 28 sind wieder abwechselnd übereinander angeordnet. Die Piezoschichten 5, 25, 35, 36, und die Elektrodenschichten 22, 23, 26, 27, 28 sind, insbesondere lediglich, auf einer Seite der Trägerschicht 6 angeordnet.

Figur 4 zeigt ein Ausführungsbeispiel der Trägerschicht 6 in einer Schnittansicht. Wie hier zu sehen ist, ist die Trägerschicht 6 aus weiteren Schichten 37 - 43 ausgebildet. Die Trägerschicht 6 umfasst zumindest eine Oxidschicht 37 - 40 und zumindest eine Metallschicht 41 - 43. Insbesondere mittels der Hubachse 3 ist wieder klar, was oberhalb und unterhalb bedeutet.

Die zumindest eine Metallschicht 41 - 43 kann vorzugsweise aus Aluminium ausgebildet sein. Zusätzlich oder alternativ kann die zumindest eine Oxidschicht 37 - 40 aus Siliziumoxid ausgebildet sein. Mittels dieser Materialien kann die Trägerschicht 6 und die zumindest eine darauf angeordnete Piezoschicht 5, 25, 35, 36 mit bekannten Herstellungsverfahren, beispielsweise mittels Verfahren, die in der Halbleitertechnologie, beispielsweise CMOS-kompatiblen Verfahren, eingesetzt werden, ausgebildet werden.

Die zumindest eine Oxidschicht 37 - 40 und/oder zumindest eine Metallschicht 41 - 43 weisen ferner den Vorteil auf, dass diese thermisch bis zu hohen Temperaturen, beispielsweise bis 1200°C - 1400°C, beständig sind. Infolgedessen können die Piezoschichten 5, 25, 35, 36 und/oder die Elektrodenschichten 22, 23, 26 - 29 mittels Verfahren der Halbleitertechnologie, beispielsweise den CMOS-kompatiblen Verfahren, aufgebracht werden. Beispielsweise können die Piezoschichten 5, 25, 35, 36 und/oder die Elektrodenschichten 22, 23, 26-29 mittels eines CVD-Verfahrens (chemische Gasphasenabscheidung) aufgebracht werden.

In diesem Ausführungsbeispiel umfasst die Trägerschicht 6 vier Oxidschichten 37 - 40 und drei Metallschichten 41 - 43, die, wie hier zu sehen ist, vorteilhafterweise abwechselnd in Richtung der Hubachse 3 übereinander angeordnet sind. In Richtung der Hubachse 3 ist außerdem oben und unten eine Oxidschicht 37, 40 angeordnet. Auf der hier gezeigten ersten oder vierten Oxidschicht 37, 40 kann die zumindest eine Piezoschicht 5, 25, 35, 36 angeordnet werden. Vorteilhaft ist es, wenn die zumindest eine Piezoschicht 5, 25, 35, 36 auf einer Oxidschicht 37 - 40 angeordnet ist, da die Oxidschicht 37 - 40 temperaturbeständig und gut bearbeitbar ist. Auf der Seite, auf der keine Piezoschicht 5, 25, 35, 36 angeordnet ist, kann die Trägerschicht 6 mit einer Metallschicht 41 - 43 oder einer Oxidschicht 37 - 40 abschließen.

Des Weiteren kann auf die Oxidschicht 37 - 40 auch erst eine Elektrodenschicht 22, 23, 26 - 29 angrenzen, an die dann wiederum die Piezoschicht 5, 25, 35, 36 angrenzt. Dies ist allerdings nur der Fall, wenn eine Elektrode für die Piezoschicht 5, 25, 35, 36 auch als Elektrodenschicht 22, 23, 26 - 29 ausgebildet ist. Die Elektrode für die Piezoschicht 5, 25, 35, 36 kann auch an einer Stirnseite der Piezoschicht 5, 25, 35, 36 angeordnet sein. Dann könnte die Piezoschicht 5, 25, 35, 36 unmittelbar an die erste oder vierte Oxidschicht 37, 40 angrenzen.

Des Weiteren kann sich eine Elektrodenschicht 22, 23, 26 - 29 auch abschnittsweise zwischen Piezoschicht 5, 25, 35, 36 und der angrenzenden Oxidschicht 37 - 40 erstrecken.

Wie hier gezeigt ist, stehen die Oxidschichten 37 - 40 seitlich über die Metallschichten 41 - 43 weg. Zusätzlich oder alternativ können auch einige, insbesondere alle, Oxidschichten 37 - 40 und Metallschichten 41 - 43 bündig und/oder deckungsgleich sein.

Wie in der Figur 4 zu sehen ist, umfasst die hier gezeigte Trägerschicht 6 vier Oxidschichten 37 - 40 und drei Metallschichten 41 - 43. Alternativ kann die Trägerschicht 6 auch lediglich zwei oder eine Oxidschichten 37 - 40 und eine Metallschicht 41 - 43 umfassen. Weiterhin alternativ kann die Trägerschicht 6 auch mehrere Oxidschichten 37 - 40, beispielsweise elf, und mehrere Metallschichten 41 - 43, beispielsweise zehn, umfassen.

Von Vorteil ist es, wenn die Trägerschicht 6 in Richtung der Hubachse 3 oben und unten eine Oxidschicht 37 - 40 aufweist. Ferner kann die oberste und die unterste Schicht des schichtweisen Aufbaus der Trägerschicht 6 eine Oxidschicht 37 - 40 sein. Zusätzlich ist jeweils zwischen zwei Oxidschichten 37 - 40 eine Metallschicht 41 - 43 angeordnet. Somit ist die Anzahl der Oxidschichten 37 - 40 um eins größer als die Anzahl der Metallschichten 41 - 43.

Die Oxidschichten 37 - 40 weisen den Vorteil auf, dass diese gut weiterbearbeitet werden können. Beispielsweise können die Oxidschichten 37 - 40 mittels chemisch-mechanischem Polierens bearbeitet werden. Dadurch wird eine flache und/oder ebene Fläche auf der Oxidschicht 37 - 40 gebildet, auf der dann die zumindest eine Piezoschicht 5, 25, 35, 36 und/oder die Elektrodenschicht 22, 23, 26 - 29 angeordnet wird. Deshalb ist es von Vorteil, wenn die oberste und die unterste Schicht der Trägerschicht eine Oxidschicht 37 - 40 ist.

Hier sind vier Oxidschichten 37 - 40 und drei Metallschichten 41 - 43, um eine Dicke 34 des Piezoelements 4 von ungefähr 7µm zu erhalten, was vorteilhaft für die Auslenkung und für die Leistungsfähigkeit des Piezoelements 4 ist. Die Anzahl der Oxidschichten 37 - 40 und Metallschichten 41 - 43 und somit die Dicke 34 des Piezoelements 4 hängt hierbei auch von der Länge 33 des Piezoelements 4 ab.

### Bezugszeichenliste

- 1: MEMS-Wandlers
- 2: Träger
- 3: Hubachse
- 4: Piezoelement
- 5: erste Piezoschicht
- 6: Trägerschicht
- 8: freies Ende
- 9: Koppelelement
- 10: Federelement
- 11: Membran
- 12: erste Koppelplatte
- 13: Membranrahmen
- 14: neutrale Ebene
- 15: Oberseite
- 16: Unterseite
- 22: erste Elektrodenschicht
- 23: zweite Elektrodenschicht
- 25: zweite Piezoschicht
- 26: dritte Elektrodenschicht
- 27: vierte Elektrodenschicht
- 28: fünfte Elektrodenschicht
- 33: Länge
- 34: Dicke
- 35: dritte Piezoschicht
- 36: vierte Piezoschicht
- 37: erste Oxidschicht
- 38: zweite Oxidschicht
- 39: dritte Oxidschicht
- 40: vierte Oxidschicht
- 41: erste Metallschicht
- 42: zweite Metallschicht
- 43: dritte Metallschicht

## Patentansprüche

1. MEMS-Wandler (1), insbesondere MEMS-Schallwandlereinheit, vorzugsweise zum Erzeugen und/oder Erfassen von Schallwellen im hörbaren Wellenlängenspektrum und/oder im Ultraschallbereich, mit einem Träger (2) und
mit zumindest einem am Träger (2) angeordneten und in Richtung einer Hubachse (3) auslenkbaren Piezoelement (4),
das zumindest eine Piezoschicht (5, 25, 35, 36) und zumindest eine Trägerschicht (6) aufweist, wobei mittels der zumindest einen Piezoschicht (5, 25, 35, 36) elektrische Signale und Auslenkungen des Piezoelements (4) ineinander umwandelbar sind,
**dadurch gekennzeichnet,**
**dass** die Trägerschicht (6) zumindest eine Metallschicht (41 - 43) und zumindest eine Oxidschicht (37 - 40) umfasst.

2. MEMS-Wandler nach dem vorherigen Anspruch, **dadurch gekennzeichnet, dass** die Piezoschicht (5, 25, 35, 36) aus Scandium-Aluminium-Nitrit ausgebildet ist, wobei ein Scandiumanteil zwischen 30% und 70%, vorzugsweise 30%, 40 % oder 50%, beträgt.

3. MEMS-Wandler nach einem oder mehreren der vorherigen Ansprüche, **dadurch gekennzeichnet, dass** die Metallschicht (41 - 43) eine Aluminiumschicht ist und/oder
dass die Oxidschicht (37 - 40) eine Siliziumoxidschicht ist.

4. MEMS-Wandler nach dem vorherigen Anspruch, **dadurch gekennzeichnet, dass** die Trägerschicht (6) mehrere Metallschichten (41 - 43) und mehrere Oxidschichten (37 - 40) umfasst, die vorzugsweise abwechselnd übereinander angeordnet und/oder gestapelt sind.

5. MEMS-Wandler nach einem oder mehreren der vorherigen Ansprüche, **dadurch gekennzeichnet, dass** die zumindest eine Piezoschicht (5, 25, 35, 36) auf der Oxidschicht (37 - 40) angeordnet ist.

6. MEMS-Wandler nach einem oder mehreren der vorherigen Ansprüche, **dadurch gekennzeichnet, dass** in Richtung der Hubachse (3) unterhalb oder oberhalb der Trägerschicht (6) eine Piezoschicht (5, 25, 35, 36) angeordnet ist.

7. MEMS-Wandler nach einem oder mehreren der vorherigen Ansprüche, **dadurch gekennzeichnet, dass** in Richtung der Hubachse (3) lediglich auf einer Seite der Trägerschicht (6) die zumindest eine Piezoschicht (5, 25, 35, 36) angeordnet ist und/oder dass in Richtung der Hubachse (3) auf einer Seite der Trägerschicht (6) die zumindest eine Piezoschicht (5, 25, 35, 36) und die dazu gegenüberliegende Seite der Trägerschicht (6) frei von der zumindest einen Piezoschicht (5, 25, 35, 36) ist.

8. MEMS-Wandler nach einem oder mehreren der vorherigen Ansprüche, **dadurch gekennzeichnet, dass** in Richtung der Hubachse (3) die zumindest eine Piezoschicht (5, 25, 35, 36), lediglich und/oder ausschließlich, zwischen Träger (2) und Trägerschicht (6) angeordnet ist.

9. MEMS-Wandler nach einem oder mehreren der vorherigen Ansprüche, **dadurch gekennzeichnet, dass** das Piezoelement (4) in dessen Längsrichtung eine Länge (33), insbesondere vom Träger (2) bis zu einem freien Ende (8) des Piezoelements (4), zwischen 0,5 mm und 2 mm aufweist.

10. MEMS-Wandler nach einem oder mehreren der vorherigen Ansprüche, **dadurch gekennzeichnet, dass** das zumindest eine Piezoelement (4) mehrere, insbesondere zwischen zwei und sechs, vorzugsweise vier, Piezoschichten (5, 25, 35, 36) umfasst und/oder
dass das zumindest eine Piezoelement (4) zumindest eine Elektrodenschicht (22, 23, 26 - 28) umfasst und/oder
dass das zumindest eine Piezoelement (4) zumindest eine Isolationsschicht umfasst.

11. MEMS-Wandler nach einem oder mehreren der vorherigen Ansprüche, **dadurch gekennzeichnet, dass** der MEMS-Wandler (1) ein Koppelelement (9) umfasst, mit dem das zumindest eine Piezoelement (4) mit einer Membran (11) koppelbar ist, und/oder
dass das Piezoelement (4) und das Koppelelement (9) mittels zumindest eines Federelements (10) miteinander gekoppelt sind, wobei das zumindest eine Federelement (10) in Längsrichtung des Piezoelements (4) vorzugsweise zwischen der Trägerschicht (6) und dem Koppelelement (9) angeordnet ist, und/oder
dass das Federelement (10), vorzugsweise ausschließlich, durch die Trägerschicht (6) und/oder ein Polymer ausgebildet ist.

12. Verwendung einer Trägerschicht (6) für einen MEMS-Wandler (1), wobei der MEMS-Wandler (1) zumindest gemäß einem der vorherigen Ansprüche ausgebildet ist und/oder wobei die Trägerschicht (6) gemäß zumindest einem der Ansprüche ausgebildet ist.

13. Verfahren zur Herstellung eines MEMS-Wandlers (1), insbesondere MEMS-Schallwandlereinheit, vorzugsweise zum Erzeugen und/oder Erfassen von Schallwellen im hörbaren Wellenlängenspektrum und/oder im Ultraschallbereich,
wobei der MEMS-Wandler (1) vorzugsweise zumindest ein Merkmal der vorangegangenen Ansprüche aufweist,
bei dem an einem Träger (2) zumindest ein in Richtung einer Hubachse (3) auslenkbares Piezoelement (4) angeordnet wird,
das zumindest zwei Piezoschichten (5, 25, 35, 36) und zumindest eine Trägerschicht (6) aufweist, wobei mittels den zumindest zwei Piezoschichten (5, 25, 35, 36) elektrische Signale und Auslenkungen des Piezoelements (4) ineinander umwandelbar sind,
**dadurch gekennzeichnet,**
**dass** die Trägerschicht (6) als zumindest eine Metallschicht (41 - 43) und zumindest eine Oxidschicht (37 - 40) ausgebildet wird.

14. Verfahren nach dem vorherigen Anspruch, **dadurch gekennzeichnet, dass** eine Oxidschicht (37 - 40), insbesondere eine Siliziumoxidschicht, der Trägerschicht (6) mittels chemisch-mechanischem Polierens bearbeitet wird und/oder
dass die Piezoschichten (5, 25, 35, 36) mittels Halbleiterherstellungsverfahren auf der Trägerschicht (6) ausgebildet werden.

15. Verfahren nach einem oder mehreren der vorherigen Ansprüche,
**dadurch gekennzeichnet, dass** die Piezoschichten (5, 25, 35, 36) auf der Trägerschicht (6), insbesondere auf der Oxidschicht (37 - 40), abgeschieden werden und/oder
dass die Piezoschichten (5, 25, 35, 36) auf der Trägerschicht (6) und/oder die Trägerschicht (6) mittels chemischer Gasphasenabscheidung ausgebildet werden und/oder
dass nach dem Ausbilden der Piezoschichten (5, 25, 35, 36) und/oder der Trägerschicht (6) zumindest ein Bereich, insbesondere mittels Ätzens, entfernt wird.
